# EUROPÄISCHE PATENTSCHRIFT

(11) **EP 1 712 746 B1**
(45) Veröffentlichungstag und Bekanntmachung des Hinweises auf die Patenterteilung: **07.01.2009**
(21) Anmeldenummer: 06003865.0
(22) Anmeldetag: 25.02.2006
(51) Int. Cl.: F01L 9/04, H01L 41/083

(54) **Elektrische Stellvorrichtung zur variablen Betätigung eines Gaswechselventils**
Electric actuator for variable drive of a gas exchange valve
Dispositif d'actionnnement electrique pour actionnement variable d'une soupape

(30) Priorität: 15.04.2005 DE 102005017410
(43) Veröffentlichungstag der Anmeldung: 18.10.2006
(73) Patentinhaber: Schaeffler KG, 91074 Herzogenaurach (DE)
(72) Erfinder: Elendt, Harald, 96146 Altendorf (DE); Geiger, Uwe, Dr., 14532 Kleinmachnow (DE)

(56) Entgegenhaltungen:
- EP-A- 0 143 128
- EP-A- 0 404 965
- EP-A- 0 962 628
- US-A- 4 721 447
- US-A- 4 762 095
- US-A1- 2004 104 368

## Beschreibung

### Gebiet der Erfindung

Die Erfindung betrifft eine elektrische Stellvorrichtung zur variablen Öffnungs- und Schließbetätigung eines Gaswechselventils in einem Zylinderkopf einer Brennkraftmaschine. Die Stellvorrichtung umfasst einen im Zylinderkopf ortsfest abgestützten Linearaktuator und einen im Betätigungsfluss zwischen einem Stößel des Linearaktuators und dem Gaswechselventil angeordneten Ventilhebel. Dieser übersetzt einen Gesamthub des Stößels in einen demgegenüber größeren Gesamthub des Gaswechselventils. Der Linearaktuator umfasst zumindest eine elektrisch ansteuerbare Schrittmotoreinheit, die den Stößel sukzessiv um jeweils einen diskreten Einzelhub verlagert. Dabei ist der Gesamthub des Stößels durch Aufsummierung einer veränderbaren Anzahl diskreter Einzelhübe variabel einstellbar. In der Schrittmotoreinheit ist ein in Reihe geschaltete Piezokeramikscheiben umfassendes und elektrisch ansteuerbares Piezostapelelement angeordnet, das in Hubrichtung des Stößels wirksam ist und bei Änderung einer elektrischen Spannung am Piezostapelelement reversibel um den diskreten Einzelhub expandiert oder kontrahiert und das einenends ortsfest im Zylinderkopf abgestützt ist.

### Hintergrund der Erfindung

Bei solchen im Stand der Technik an sich bekannten Piezostapelelementen macht man sich den so genannten inversen piezoelektrischen Effekt zunutze, wonach das Piezostapelelement auf Änderung einer elektrischen Spannung mit einer Längenänderung innerhalb extrem kleiner, im Mikrosekundenbereich liegender Reaktionszeiten unter Erzeugung hoher Kräfte reagiert. In Brennkraftmaschinen finden Piezostapelelemente beispielsweise Anwendung als Aktuatoren in Dieselinjektoren, wie es zur Vertiefung der Kenntnisse über Piezoaktuatoren in dem nachfolgend genannten Buch beschrieben ist: "Aktor-Sensorverhalten von Piezoelementen in Kfz-Diesel-Einspritzsystemen" von Michael Schugt, das als erste Auflage im Jahr 2002 im Shaker-Verlag erschien.

Eine Stellvorrichtung der eingangs genannten Art, die einen Linearaktuator mit einem in Hubrichtung des Stößels wirksamen Piezostapelelement aufweist, ist aus der als gattungsbildend betrachteten EP 0 143 128 A1 vorbekannt. Der Hub des Piezostapelelements richtet sich nach der angelegten elektrischen Spannung und kann folglich auch zur Bildung einer Schrittmotoreinheit dienen, die den Stößel sukzessiv um jeweils einen diskreten Einzelhub verlagert. Der einem Einzelhub entsprechende oder wahlweise aus Einzelhüben veränderlicher Anzahl aufsummierte Gesamthub des Stößels wird über den Ventilhebel auf das Gaswechselventil übertragen.

Da sich jedoch der Gesamthub des Stößels - unabhängig von seinem Hubverlauf mit etwaigen Einzelhüben - hauptsächlich nach der maximal am Piezostapelelement anlegbaren elektrischen Spannung richtet und die für Piezostapelelemente typischen kleinen Werte annimmt, wird der Stößelhub mit einem gegenüber konventionellen, nockengesteuerten Ventiltrieben extrem hohen Hebelübersetzungsverhältnis auf das Gaswechselventil übertragen. Ein derartiges Übersetzungsverhältnis ist jedoch nicht nur wegen der entsprechend hohen und verschleißfördernden Kontaktkräfte zwischen Stößel und Ventilhebel als nachteilig anzusehen, sondern führt generell auch zu einer ausgangsseitigen Verstärkung von Streuungen der Eingangsgröße, d.h. in diesem Fall des Stößelhubs. Mit anderen Worten wirken sich insbesondere durch Bauteiltoleranzen oder auch durch ungleichmäßige elektrische Ansteuerung des Piezostapelelements bedingte Streuungen des Stößelhubs in verstärktem Maße auf die Steuerzeiten und/oder den Hubverlauf des Gaswechselventils mit entsprechender Beeinträchtigung der Ladungswechselqualität der Brennkraftmaschine aus.

In der DE 36 16 540 A1ist eine elektrische Stellvorrichtung mit einem Linearaktuator auf Basis eines elektromagnetischen Feder-Masse-Schwingers offenbart. Dessen Huberzeugung erfolgt mittels eines mit dem Stößel verbundenen Ankers, der, von Federkräften angetrieben, zwischen variabel ansteuerbaren Elektromagneten schwingt, die zum Fangen und Halten des Ankers dienen. Der Stößel betätigt einen mit dem Gaswechselventil in Wirkverbindung stehenden Schwinghebel, wobei der Stößelhub bei dessen Übertragung auf das Gaswechselventil aufgrund der am Schwinghebel wirksamen Hebelarme vergrößert wird. Obwohl diese Maßnahme eine einfache, kostengünstige und robuste Möglichkeit bietet, den in der technischen Ausführung meist erheblich eingeschränkten Hub des elektromagnetischen Feder-Masse-Schwingers im Hinblick auf einen widerstandsarmen Ladungswechsel der Brennkraftmaschine ausreichend zu erhöhen, verbleiben dennoch die prinzipbedingten und bislang nicht oder nur mit unverhältnismäßig hohem Aufwand zu beseitigenden Nachteile dieser Linearaktuatorbauart.

Diese Nachteile liegen hauptsächlich darin begründet, dass sich der Anker während des Hubs in einer Freiflugphase zwischen den Elektromagneten befindet, in der keine oder allenfalls nur sehr ungenaue Aussagen über den aktuellen Aufenthaltsort und die Geschwindigkeit des Ankers und somit des Stößels sowie des Gaswechselventils getroffen werden können. Dies führt einerseits zu einem nicht reproduzierbaren Hubverlauf des Ankers. Andererseits wirken im Nahbereich der Elektromagneten exponentiell ansteigende Magnetkräfte auf den Anker, woraus akustisch unakzeptable bis mechanisch unzulässig hohe Aufsetzgeschwindigkeiten des schließenden Gaswechselventils resultieren können. Aufgrund der hohen Aufsetzgeschwindigkeiten tritt bestenfalls ein schnell zunehmender Ventilsitzeinschlag auf; schlimmstenfalls können sie zu einem Abreißen des Gaswechselventils führen. Außerdem kann es in Folge der hohen Auftreffgeschwindigkeit des Ankers auf der ihn anziehenden Polfläche des Elektromagneten zu einem so genannten Prellen des Ankers kommen. Dieses Prellen verursacht entweder ein thermodynamisch ungünstiges mehrfaches Nachöffnen des Gaswechselventils oder, im Falle eines vollständigen Abfallen des Ankers von der Polfläche des Elektromagneten, ein permanent geöffnetes Gaswechselventil mit Ausfall des Arbeitsprozesses des entsprechenden Zylinders oder der ganzen Brennkraftmaschine.

Ein weiterer Nachteil eines solchen Linearaktuators liegt in dessen begrenzter Eigenfrequenz begründet, die einem vergleichsweise großen und selbst durch frühes und/oder starkes Bestromen der Elektromagneten nicht wesentlich zu reduzierenden Zeitbedarf für das Öffnen und Schließen des Gaswechselventils entspricht. Diese Eigenschaft führt insbesondere zu Beginn des Öffnens von Auslassventilen, die zu diesem Zeitpunkt noch mit einem hohen Zylinderinnendruck als Gegenkraft beaufschlagt sind, zu einem verlangsamten Öffnungsverlauf. Insofern kann auch das nutzbare Drehzahlband der Brennkraftmaschine durch elektromagnetische Linearaktuatoren erheblich eingeschränkt sein, da die zum Öffnen und Schließen des Gaswechselventils zur Verfügung stehende Zeit mit zunehmender Drehzahl der Brennkraftmaschine abnimmt. Als Abhilfemaßnahme hierzu ist in der EP 0 962 628 A1 ein in Öffnungsrichtung des Ankers wirkender Piezoaktuator vorgeschlagen, der jedoch lediglich ein initiales Lösen des Ankers vom schließenden Elektromagneten beschleunigt.

Insofern bleiben die prinzipbedingten Nachteile der vorgenannten Linearaktuatoren weitestgehend bestehen, die im Falle der elektromagnetischen Linearaktuatoren darüber hinaus auch noch den Nachteil haben, dass zwar die Steuerzeiten des Gaswechselventils variabel einstellbar sind, jedoch dessen Hubhöhe nicht oder nur mit unvertretbar hohem Steuerungs- oder Regelungsaufwand beeinflusst werden kann.

### Aufgabe der Erfindung

Aufgabe der Erfindung ist es daher, eine elektrische Stellvorrichtung zur variablen Öffnungs- und Schließbetätigung des Gaswechselventils zu schaffen, bei welcher die zitierten Nachteile beseitigt sind. Insbesondere soll die Stellvorrichtung einen Linearaktuator aufweisen, der einen reproduzierbaren Hubverlauf des Stößels bei ausreichend kleinen Aufsetzgeschwindigkeiten des Gaswechselventils in dessen Ventilsitz gewährleistet. Darüber hinaus soll neben den Steuerzeiten auch die Hubhöhe des Gaswechselventils variabel einstellbar sein. Schließlich soll der Linearaktuator auch einen Betrieb der Brennkraftmaschine bei sehr hohen Drehzahlen durch schnelles Öffnen- und Schließen der Gaswechselventile ermöglichen.

### Zusammenfassung der Erfindung

Erfindungsgemäß wird diese Aufgabe dadurch gelöst, dass das Piezostapelelement anderenends mit einem im Zylinderkopf längsbeweglich gelagerten Mitnehmer der Schrittmotoreinheit in Wirkverbindung steht, welcher Mitnehmer dem Einzelhub des Piezostapelelements folgt und mit dem Stößel rutschfest verbindbar ist.

Obwohl die einzelnen Piezokeramikscheiben einen lediglich im ein- oder zweistelligen Mikrometerbereich liegenden Hub erzeugen, kann durch deren Reihenschaltung zu dem Piezostapelelement ein Einzelhub generiert werden, dessen Aufsummierung eine für Gaswechselventilhübe geeignete Größenordnung erreicht. Durch die Synthese des Gesamthubs aus diskreten Einzelhüben der Schrittmotoreinheit lässt sich neben einer Steuerzeitenänderung auch die Hubhöhe des Gaswechselventils dadurch variieren, dass eine unterschiedliche Anzahl von Einzelhüben aufsummiert wird. Darüber hinaus sind der aktuelle Hub und die Geschwindigkeit des Gaswechselventils als für den Ladungswechsel und die Aufsetzgeschwindigkeit relevante Zustandsgrößen zumindest zu Beginn und am Ende der diskreten Einzelhübe bekannt. So lässt sich in Verbindung mit einer geeigneten elektrischen Ansteuerung der Schrittmotoreinheit ein an den jeweiligen Betriebszustand der Brennkraftmaschine angepasster Gesamthub des Gaswechselventils und insbesondere dessen hinsichtlich Akustik und mechanischer Belastung optimale Aufsetzgeschwindigkeit einstellen. Die Schrittmotoreinheit erlaubt darüber hinaus eine bedarfsgerechte Hubverlaufsformung, die beispielsweise ein kontrolliertes Mehrfachöffnen des Gaswechselventils oder einen den Freigang zum Kolben berücksichtigenden Hubverlauf ermöglicht.

Insofern bietet die erfindungsgemäße Stellvorrichtung dem Motorenkonstrukteur ein erhebliches Potenzial, die Variabilität der Gaswechselventilbetätigung auch als Werkzeug für unkonventionelle Betriebs- und Brennverfahrensstrategien der Brennkraftmaschine einzusetzen. Zu diesen Strategien zählen beispielsweise homogene Selbstzündungsbrennverfahren, eine Änderung des effektiven Verdichtungsverhältnisses, eine Erhöhung der internen Abgasrückführungsraten sowie eine Erhöhung der Zylinderfüllung durch Nachlade- oder so genannte Impulsaufladeverfahren.

Der Mitnehmer ist zweckmäßigerweise als piezoelektrische Klemmvorrichtung ausgebildet, die einen elastisch verformbaren und zu einer Außenmantelfläche des Stößels benachbart verlaufenden Radialabschnitt aufweist, der von ein oder mehreren elektrisch ansteuerbaren Piezokeramikelementen der Klemmvorrichtung quer zur Längsrichtung des Stößels kraftbeaufschlagbar ist. Dabei ist ein Radialspalt zwischen dem Radialabschnitt und der Außenmantelfläche des Stößels durch Expansion der Piezokeramikelemente infolge Änderung einer elektrischen Spannung an den Piezokeramikelementen zur rutschfesten Verbindung des Mitnehmers mit dem Stößel aufhebbar. Demnach können die hervorragenden dynamischen Eigenschaften bei gleichzeitig hoher Krafterzeugung der Piezokeramikelemente zur vollständigen und reproduzierbaren Übertragung der von dem Piezostapelelement erzeugten Einzelhübe auf den Stößel genutzt werden. Dabei kann die Klemmvorrichtung über eine am Radialabschnitt und/oder an der Außenmantelfläche des Stößels angeordnete Mikroverzahnung formschlüssig mit dem Stößel verbindbar sein.

Um die Gefahr eines Berstens des Piezostapelelements dauerhaft zu verhindern, soll die Schrittmotoreinheit ein einenends ortsfest im Zylinderkopf abgestütztes Federmittel aufweisen, das anderenends den Mitnehmer in Richtung des Piezostapelelements kraftbeaufschlagt. Dabei kann es je nach Anordnung von Piezostapelelement, Federmittel und Mitnehmer in der Schrittmotoreinheit notwendig oder zur Verkleinerung des Bauraumbedarfs sowie zur Herstellung der Komponenten der Stellvorrichtung vorteilhaft sein, wenn das Piezostapelelement und/oder das Federmittel einen im wesentlichen kreisförmigen Querschnitt mit jeweils einer zentrischen Ausnehmung aufweisen, in der der Stößel verläuft.

In einer besonders bevorzugten Ausführungsform der Stellvorrichtung umfasst der Linearaktuator zwei Schrittmotoreinheiten, die so ansteuerbar sind, dass das Piezostapelelement der ersten Schrittmotoreinheit um den Einzelhub expandiert, während das Piezostapelelement der zweiten Schrittmotoreinheit um den Einzelhub kontrahiert. Dabei ist der Stößel mit den Mitnehmern der Schrittmotoreinheiten alternierend verbunden. Durch die Zusammenschaltung von zwei Schrittmotoreinheiten ist eine nahezu unterbrechungsfreie Aufsummierung der Einzelhübe zum Gesamthub möglich, wodurch sich die durchschnittliche Geschwindigkeit sowie die Höhe des Gesamthubs näherungsweise verdoppeln lassen.

In einer ersten vorteilhaften Ausführungsvariante ist der Ventilhebel als Schwinghebel ausgebildet, der vom Stößel zwischen einem als Zylinderkopflagerstelle dienenden ersten Endabschnitt und einem als Anlenkstelle für das Gaswechselventil dienenden zweiten Endabschnitt beaufschlagt ist.

Je nach Architektur der Brennkraftmaschine kann der Ventilhebel in einer zweiten Ausführungsvariante auch als Kipphebel ausgebildet sein, der einen vom Stößel beaufschlagten ersten Endabschnitt, einen als Anlenkstelle für das Gaswechselventil dienenden zweiten Endabschnitt sowie eine zwischen dem ersten Endabschnitt und dem zweiten Endabschnitt angeordnete Zylinderkopflagerstelle aufweist.

Schließlich soll die Anlenkstelle als Zug-Druck-Gelenk zur Betätigung eines ventilfederkraftfreien Gaswechselventils sowohl in Öffnungsrichtung als auch in Schließrichtung des Gaswechselventils ausgebildet sein. Bei einer so ausgebildeten Kopplung von Ventilhebel und Gaswechselventil kann auf die in Schließrichtung wirkende Ventilfeder verzichtet werden, wodurch sich eine kraftreduzierte sowie reibungs- und somit verlustarme Öffnungs- und Schließbetätigung des Gaswechselventils bei geeigneter Dimensionierung des den Mitnehmer kraftbeaufschlagenden Federmittels erzielen lässt. Alternativ zu der als Zug-Druck-Gelenk ausgebildeten Anlenkstelle kann diese jedoch auch konventionell als Druck-Gelenk zur Betätigung eines von einer Schließfeder beaufschlagten Gaswechselventils ausgeführt sein.

### Kurze Beschreibung der Zeichnungen

Weitere Merkmale der Erfindung ergeben sich aus der nachfolgenden Beschreibung und aus den Zeichnungen, in denen Ausführungsbeispiele mit für die Erfindung wesentlichen Funktionselementen prinzipiell und vereinfacht dargestellt sind. Es zeigen:
- Figur 1: die Stellvorrichtung mit zwei Schrittmotoreinheiten mit Piezostapelelementen, wobei der Ventilhebel als Schwinghebel ausgebildet ist,
- Figur 2: die Stellvorrichtung analog zu Figur 1, wobei der Ventilhebel als Kipphebel ausgebildet ist und
- Figur 3: ein schematisches Hub-Zeit-Diagramm.

### Ausführliche Beschreibung der Zeichnungen

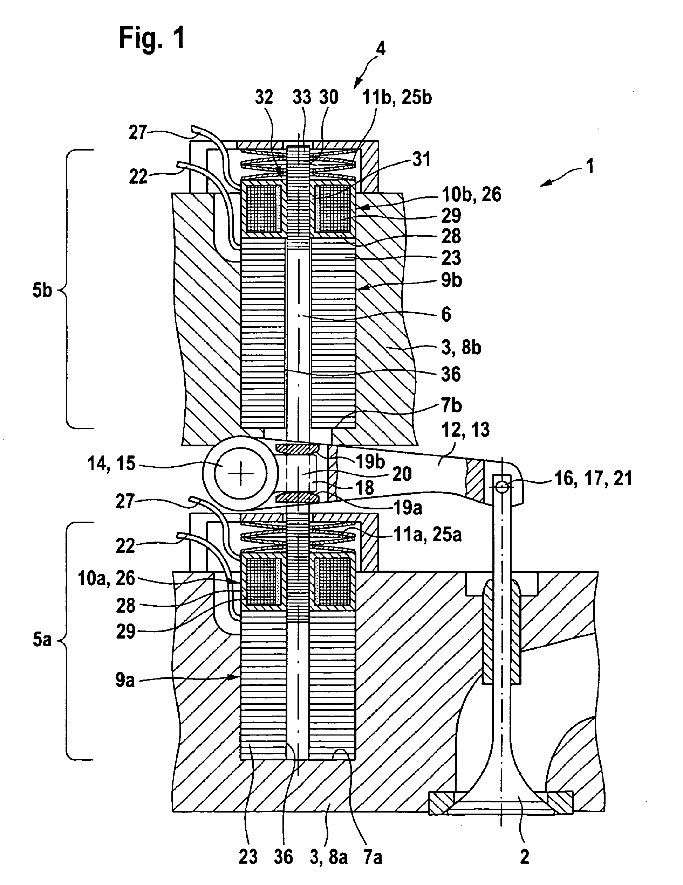

In Figur 1 ist eine erste Ausführungsvariante einer erfindungsgemäßen Stellvorrichtung 1 zur variablen Öffnungs- und Schließbetätigung eines Gaswechselventils 2 in einem Zylinderkopf 3 einer Brennkraftmaschine offenbart. Dargestellt ist ein im Zylinderkopf 3 ortsfest abgestützter Linearaktuator 4 mit zwei elektrisch ansteuerbaren Schrittmotoreinheiten 5a, 5b. Die Schrittmotoreinheiten 5a, 5b sind im gezeigten Ausführungsbeispiel zylindrisch ausgeführt und weisen eine gemeinsame und zum Gaswechselventil 2 parallel verlaufende Längsachse auf, auf der ein Stößel 6 des Linearaktuators 4 verläuft. Beide Schrittmotoreinheiten 5a, 5b stützen sich in hohlzylindrischen Ausnehmungen 7a, 7b ortsfest im Zylinderkopf 3 ab. Aus Montagegründen der Stellvorrichtung 1 kann es dabei zweckmäßig sein, den Zylinderkopf 3 mehrteilig mit fest miteinander verbundenen Trägerelementen 8a, 8b auszuführen. Demnach ist die erste Schrittmotoreinheit 5a in dem brennraumseitigen Trägerelement 8a, in dem auch das Gaswechselventil 2 verläuft, angeordnet, während die zweite Schrittmotoreinheit 5b von dem separaten Trägerelement 8b aufgenommen ist, das auf das Trägerelement 8a aufgesetzt und fest mit diesem verschraubt ist.

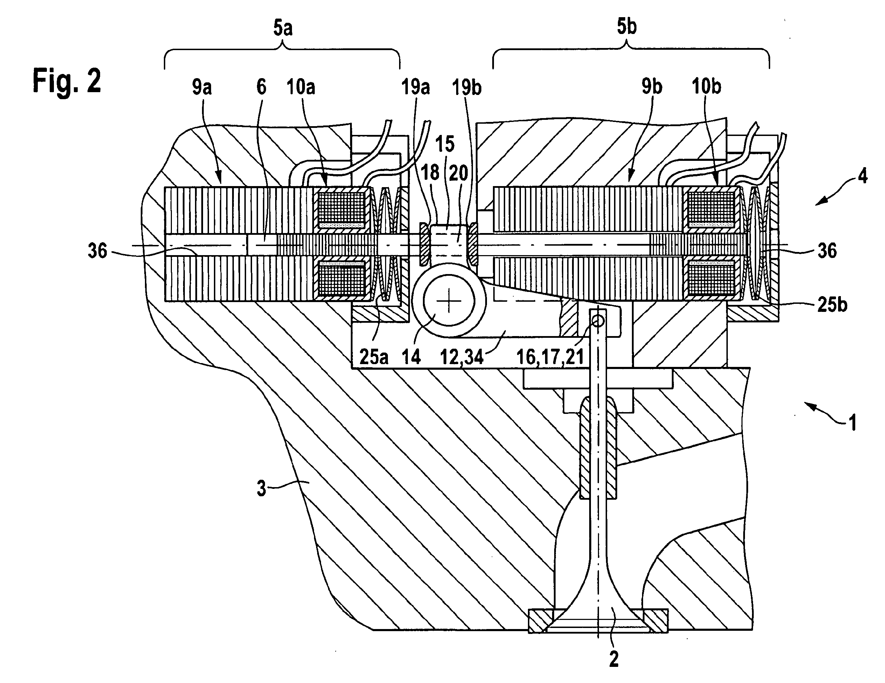

Die Schrittmotoreinheiten 5a, 5b setzen sich jeweils aus einer Reihenschaltung eines Piezostapelelements 9a, 9b, eines Mitnehmers 10a, 10b sowie eines an dem zugehörigen Trägerelement 8a, 8b abgestützten Federmittels 11a, 11 b zusammen und sind über den gemeinsamen Stößel 6 miteinander gekoppelt. Der Stößel 6 betätigt einen zwischen den Schrittmotoreinheiten 5a, 5b drehbar gelagerten und das Gaswechselventil 2 beaufschlagenden Ventilhebel 12 derart, dass ein Hub des Stößels 6 in einen demgegenüber größeren Hub des Gaswechselventils 2 übersetzt wird. Der Ventilhebel 12 ist in dieser Ausführungsvariante als Schwinghebel 13 ausgebildet und wird von dem Stößel 6 zwischen einem als Zylinderkopflagerstelle 14 dienenden ersten Endabschnitt 15 und einem als Anlenkstelle 16 für das Gaswechselventil 2 dienenden zweiten Endabschnitt 17 sowohl in Öffnungs- als auch in Schließrichtung des Gaswechselventils 2 beaufschlagt. Zu diesem Zweck weist der Schwinghebel 13 einen im Bereich der Zylinderkopflagerstelle 14 ausgebildeten Steg 18 auf, der von Kontaktflächen 19a, 19b des Stößels 6 in beide Drehrichtungen des Schwinghebels 13 beaufschlagt ist. Der Stößel 6 umgreift den Steg 18 mit einer seitlich zum Steg 18 verlaufenden Kröpfung 20, wobei die linear bewegten Kontaktflächen 19a, 19b zur Vermeidung von Kantenträgern gegenüber dem rotativ bewegten Steg 18 konvex ausgeführt sind. Weiterhin ist die Anlenkstelle 16 des Schwinghebels 13 als Zug-Druck-Gelenk 21 ausgebildet, um das von Ventilfederkräften freie Gaswechselventil 2 sowohl in Öffnungs- als auch in Schließrichtung zu betätigen. Das Zug-Druck-Gelenk 21 ist in den Figuren 1 und 2 vereinfacht als Drehgelenk dargestellt, das bei einer konkreten Ausführung auch den lateralen Versatz zwischen Ventilhebel 12 und Gaswechselventil 2 bei dessen Betätigung ausgleichen muss. Alternativ zu dieser Ausführungsform ist jedoch auch eine als konventionelles Druck-Gelenk ausgebildete Anlenkstelle 16 zum Gaswechselventil 2 denkbar, das dann in herkömmlicher Weise über eine Ventilfeder in Schließrichtung beaufschlagt ist.

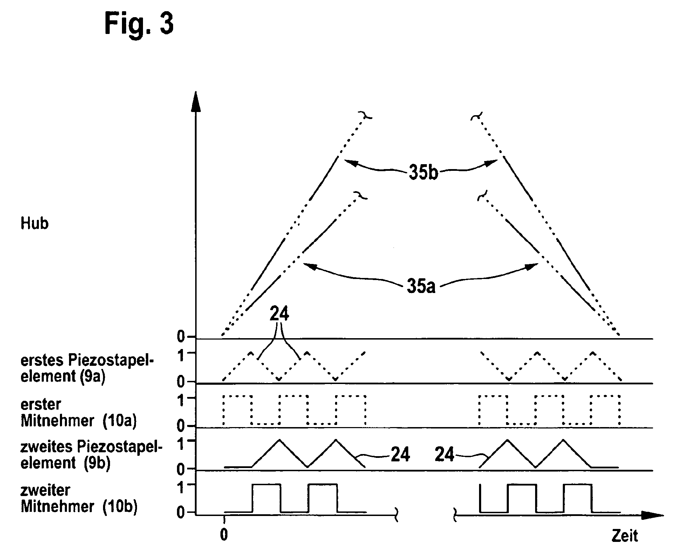

Die Piezostapelelemente 9a, 9b sind über je eine elektrische Versorgungsleitung 22 unabhängig voneinander ansteuerbar, umfassen in Reihe geschaltete und vorzugsweise folienartig ausgebildete Piezokeramikscheiben 23 und sind in Hubrichtung des Stößels 6 aufgrund des eingangs geschilderten inversen piezoelektrischen Effekts wirksam. Demnach expandiert oder kontrahiert jedes Piezostapelelement 9a, 9b reversibel um einen diskreten Einzelhub 24 (s. Figur 3) infolge Änderung einer elektrischen Spannung am Piezostapelelement 9a, 9b. Dadurch, dass die Schrittmotoreinheiten 5a, 5b einenends ortsfest im Zylinderkopf 3 abgestützt sind, wird der Einzelhub 24 jeweils auf den längsbeweglich gelagerten Mitnehmer 10a, 10b übertragen, der von dem als Tellerfederpaket 25a, 25b ausgebildeten Federmittel 11a, 11 b in Richtung des Piezostapelelements 9a, 9b kraftbeaufschlagt ist und somit der Bewegung des Piezostapelelements 9a, 9b sowohl bei dessen Expansion als auch bei dessen Kontraktion folgt.

Jeder mit dem Stößel 6 rutschfest verbindbare Mitnehmer 10a, 10b ist hier als piezoelektrische Klemmvorrichtung 26 ausgebildet. Die Klemmvorrichtung 26 besteht aus einem zylindrischen und mit einer elektrischen Versorgungsleitung 27 verbundenen Außengehäuse 28, in dem ein oder mehrere elektrisch ansteuerbare Piezokeramikelemente 29 angeordnet sind. Deren Wirkungsweise basiert ebenfalls auf dem inversen piezoelektrischen Effekt, der bei Änderung einer elektrischen Spannung zu einer Expansion der Piezokeramikelemente 29 quer zur Längsrichtung des Stößels 6 führt. Dabei wird ein zu einer Außenmantelfläche 30 des Stößels 6 benachbart verlaufender Radialabschnitt 31 des Außengehäuses 28 elastisch soweit verformt, dass ein Radialspalt 32 zwischen der Außenmantelfläche 30 und dem Radialabschnitt 31 aufgehoben wird. Zur Steigerung der Rutschfestigkeit der so hergestellten Verbindung der Klemmvorrichtung 26 mit dem Stößel 6 wirkt diese formschlüssig, indem der Radialabschnitt 31 und/oder die Außenmantelfläche 30 des Stößels 6 mit einer Mikroverzahnung 33 versehen ist.

In Figur 2 ist eine zweite Ausführungsvariante der erfindungsgemäßen Stellvorrichtung 1 dargestellt. In diesem Fall ist der Ventilhebel 12 als Kipphebel 34 ausgebildet, dessen Zylinderkopflagerstelle 14 zwischen dem vom Stößel 6 beaufschlagten ersten Endabschnitt 15 und dem als Anlenkstelle 16 für das Gaswechselventil 2 dienenden zweiten Endabschnitt 17 angeordnet ist. Analog zu dem vorher beschriebenen Schwinghebel 13 geht von der Zylinderkopflagerstelle 14 des Kipphebels 34 ebenfalls ein Steg 18 aus, der von den konvexen und mittels der seitlich zum Steg 18 verlaufenden Kröpfung 20 verbundenen Kontaktflächen 19a, 19b des Stößels 6 beaufschlagt ist.

Es ist weiterhin erkennbar, dass die Längsachse des hier dargestellten Linearaktuators 4 quer zur Längsachse des Gaswechselventils 2 verläuft. Dies dient jedoch lediglich zur Illustration dessen, dass der Linearaktuator 4 in einem beliebigen Winkel zum Gaswechselventil 2 insbesondere in Abhängigkeit des Bauraumangebots im Zylinderkopf 3 und in dessen Umgebung und überdies unabhängig von der Ausführung des Ventilhebels 12 angeordnet sein kann. Im übrigen sind die in Figuren 1 und 2 dargestellten Ausführungsvarianten des Linearaktuators 4 in Bezug auf die erfindungswesentlichen konstruktiven Merkmale der Stellvorrichtung 1 identisch.

Nachfolgend wird ein beispielhafter Bewegungsablauf der Stellvorrichtung 1 nach Figur 2 mit Bezugnahme auf das in Figur 3 schematisch dargestellte Hub-Zeit-Diagramm beim Öffnen und Schließen des Gaswechselventils 2 näher beschrieben. In dem Hub-Zeit-Diagramm sind die Einzelhübe 24 der beiden Piezostapelelemente 9a, 9b über dem Bestromungsverlauf der zugehörigen Mitnehmer 10a, 10b über der Zeit aufgetragen. Weiterhin ist ein aus den Einzelhüben 24, die von den Schrittmotoreinheiten 5a, 5b auf den Stößel 6 übertragen werden, aufsummierter Gesamthub 35a des Stößels und ein demgegenüber vergrößerter Gesamthub 35b des Gaswechselventils 2 dargestellt. Dabei sind die Hubverläufe des ersten Piezostapelelements 9a und des ersten Mitnehmers 10a sowie deren Beitrag an den Gesamthüben 35a, 35b gepunktet dargestellt. Es ist erkennbar, dass der Bewegungsablauf auf einem getakteten und miteinander synchronisierten Zusammenspiel der Schrittmotoreinheiten 5a, 5b basiert, deren Einzelhübe 24 abwechselnd auf das Gaswechselventil 2 übertragen werden.

Für die detaillierte Beschreibung des Bewegungsablaufs wird zunächst davon ausgegangen, dass das Gaswechselventil 2 geschlossen ist (Hub=0). Zum Öffnen des Gaswechselventils 2 wird beispielsweise zunächst der erste Mitnehmer 10a bestromt (Stromanstieg von "0" auf "1 "). Sobald dessen rutschfeste Verbindung zum Stößel 6 hergestellt ist, wird das erste Piezostapelelement 9a bestromt und expandiert um den Einzelhub 24 (Expansion von "0" auf "1 "), der über den Mitnehmer 10a auf den Stößel 6 und dessen erste Kontaktfläche 19a auf den Steg 18 des Kipphebels 34 übertragen wird. Gleichzeitig wird das Tellerfederpaket 25a der ersten Schrittmotoreinheit 5a um den Einzelhub 24 gespannt. Aufgrund seiner Hebelverhältnisse übersetzt der Kipphebel 34 den Einzelhub 24 vergrößert auf das Gaswechselventil 2. Sobald der Einzelhub 24 abgeschlossen ist, wird die jeweilige Bestromung am Mitnehmer 10a und am Piezostapelelement 9a abgeschaltet (Stromabfall von "1 auf "0"). Ist die Verbindung des Mitnehmers 10a zum Stößel 6 aufgehoben, folgt der Mitnehmer 10a unter Entspannung des Tellerfederpakets 25a dem in seine Ausgangslänge kontrahierenden Piezostapelelement 9a in seine Ausgangsposition (Kontraktion von "1" auf "0") . Im wesentlichen gleichzeitig mit Abschalten der Bestromung der ersten Schrittmotoreinheit 5a werden das Piezostapelelement 9b und der Mitnehmer 10b der zweiten Schrittmotoreinheit 5b bestromt, so dass unmittelbar im Anschluss an den ersten Einzelhub 24 ein zweiter Einzelhub 24 auf das Gaswechselventil 2 sowie auf das Tellerfederpaket 25b der zweiten Schrittmotoreinheit 5b übertragen wird. Auf den zweiten Einzelhub 24 folgt ein weiterer, aus zwei Einzelhüben 24 bestehender Betätigungszyklus, der mit einem dritten von der ersten Schrittmotoreinheit 5a erzeugten Einzelhub 24 beginnt, während die Bestromung der zweiten Schrittmotoreinheit 5b abgeschaltet wird und der zweite Mitnehmer 10b unter Entspannung des zweiten Tellerfederpakets 25b und Kontraktion des zweiten Piezostapelelements 9b in seine Ausgangslänge in seine Ausgangsposition zurückkehrt. Diese Betätigungszyklen werden zur Aufsummierung der von den Schrittmotoreinheiten 5a, 5b erzeugten und auf den Stößel 6 übertragenen Einzelhübe 24 solange wiederholt, bis der gewünschte, in dem Hub-Zeit-Diagramm jedoch unterbrochen dargestellte Gesamthub 35b des Gaswechselventils 2 erreicht ist.

Das Schließen des Gaswechselventils 2 erfolgt in analoger Weise zu dessen Öffnen, wobei jedoch die Mitnehmer 10a, 10b phasenversetzt zu den zugehörigen Piezostapelelementen 9a, 9b bestromt werden. Demnach wird ein erster in Schließrichtung wirkender Einzelhub 24 beispielsweise dadurch erzeugt, dass der zweite Mitnehmer 10b bestromt und mit dem Stößel 6 verbunden ist, während das zweite Piezostapelelement 9b ausgehend von seiner expandierten Länge stromlos in seine Ausgangslänge kontrahiert. Der nunmehr mit dem Gaswechselventil 2 über die zweite Kontaktfläche 19b des Stößels 6 im Kraftfluss stehende zweite Mitnehmer 10b folgt der Bewegung des zweiten Piezostapelelements 9b dadurch, dass die für die Schließbetätigung des Gaswechselventils 2 erforderliche Arbeit im wesentlichen von dem sich entspannenden Tellerfederpaket 25b der zweiten Schrittmotoreinheit 5b aufgebracht wird. In dem Zeitintervall, in dem der in Schließrichtung wirkende Einzelhub 24 auf das Gaswechselventil 2 übertragen wird, expandiert das bestromte Piezostapelelement 9a der ersten Schrittmotoreinheit 5a und spannt das zugehörige Tellerfederpaket 25a um den Einzelhub 24. Dabei ist der erste Mitnehmer 10a unbestromt und nicht mit dem Stößel 6 verbunden.

Ein zweiter Einzelhub 24 in Schließrichtung beginnt dann mit Abschalten der Bestromung des ersten Piezostapelelements 9a und des zweiten Mitnehmers 10b, während der erste Mitnehmer 10a zur Verbindung mit dem Stößel 6 und das zweite Piezostapelelement 9b zur Expansion bestromt werden. Folglich überträgt der von der Kraft des Tellerfederpakets 25a beaufschlagte erste Mitnehmer 10a den zweiten Einzelhub 24 in Richtung des sich in seine Ausgangslänge kontrahierenden ersten Piezostapelelements 9a über die zweite Kontaktfläche 19b des Stößels 6 auf den Kipphebel 34. Gleichzeitig expandiert das zweite Piezostapelelement 9b, wobei der nicht mit dem Stößel 6 verbundene zweite Mitnehmer 10b das zugehörige Tellerfederpaket 25b zur Einleitung eines weiteren Betätigungszyklus um den Einzelhub 24 spannt. Die so erzeugte Aufsummierung der im wesentlichen ebenfalls unmittelbar aufeinanderfolgenden, in Schließrichtung wirkenden Einzelhübe 24 wird solange wiederholt, bis das Gaswechselventil 2 vollständig geschlossen ist.

Der geschilderte Ablauf zur Betätigung des Gaswechselventils 2 ist in analoger Weise für die in Figur 1 mit dem als Schwinghebel 13 ausgebildeten Ventilhebei 12 anwendbar. Da hierbei eine Expansion der Piezostapelelemente 9a, 9b in Schließrichtung des Gaswechselventils 2 wirkt, erfolgt dessen Betätigung in Öffnungsrichtung analog zum Ablauf der Schließbetätigung des Kipphebels 34 aus Figur 2. Demnach kann das wechselweise Zusammenspiel zur Betätigung des Gaswechselventils 2 allgemein auch auf beliebig modifizierte Ausführungsvarianten der Stellvorrichtung 1 übertragen werden, bei denen entweder die Drehrichtung des Ventilhebels 12 bezogen auf die Öffnungsrichtung des Gaswechselventils 2 und/oder eine oder beide Schrittmotoreinheiten 5a, 5b mit im Zylinderkopf 3 um 180° gedrehter Abstützung angeordnet sind. Dabei kann es gemäß den dargestellten Ausführungsvarianten zur Bauraumreduzierung der Stellvorrichtung 1 zweckmäßig sein, dass die Piezostapelelemente 9a, 9b und die Federmittel 11 a, 11 b einen kreisförmigen Querschnitt mit jeweils einer zentrischen Ausnehmung 36 aufweisen, in der der Stößel 6 verläuft.

### Liste der Bezugszahlen

- 1: Stellvorrichtung
- 2: Gaswechselventil
- 3: Zylinderkopf
- 4: Linearaktuator
- 5a,b: Schrittmotoreinheit
- 6: Stößel
- 7a,b: Ausnehmung
- 8a,b: Trägerelement
- 9a,b: Piezostapelelement
- 10a,b: Mitnehmer
- 11 a,b: Federmittel
- 12: Ventilhebel
- 13: Schwinghebel
- 14: Zylinderkopflagerstelle
- 15: erster Endabschnitt
- 16: Anlenkstelle
- 17: zweiter Endabschnitt
- 18: Steg
- 19a,b: Kontaktfläche
- 20: Kröpfung
- 21: Zug-Druck-Gelenk
- 22: elektrische Versorgungsleitung
- 23: Piezokeramikscheibe
- 24: Einzelhub
- 25a,b: Tellerfederpaket
- 26: Klemmvorrichtung
- 27: elektrische Versorgungsleitung
- 28: Außengehäuse
- 29: Piezokeramikelement
- 30: Außenmantelfläche
- 31: Radialabschnitt
- 32: Radialspalt
- 33: Mikroverzahnung
- 34: Kipphebel
- 35a,b: Gesamthub
- 36: Ausnehmung

## Patentansprüche

1. Elektrische Stellvorrichtung (1) zur variablen Öffnungs- und Schließbetätigung eines Gaswechselventils (2) in einem Zylinderkopf (3) einer Brennkraftmaschine, mit einem im Zylinderkopf (3) ortsfest abgestützten Linearaktuator (4) und einem im Betätigungsfluss zwischen einem Stößel (6) des Linearaktuators (4) und dem Gaswechselventil (2) angeordneten Ventilhebel (12), der einen Gesamthub (35a) des Stößels (6) in einen demgegenüber größeren Gesamthub (35b) des Gaswechselventils (2) übersetzt,
wobei der Linearaktuator (4) zumindest eine elektrisch ansteuerbare Schrittmotoreinheit (5a) umfasst, die den Stößel (6) sukzessiv um jeweils einen diskreten Einzelhub (24) verlagert,
wobei der Gesamthub (35a) des Stößels (6) durch Aufsummierung einer veränderbaren Anzahl diskreter Einzelhübe (24) variabel einstellbar ist,
wobei in der Schrittmotoreinheit (5a) ein in Reihe geschaltete Piezokeramikscheiben (23) umfassendes und elektrisch ansteuerbares Piezostapelelement (9a) angeordnet ist, das in Hubrichtung des Stößels (6) wirksam ist und bei Änderung einer elektrischen Spannung am Piezostapelelement (9a) reversibel um den diskreten Einzelhub (24) expandiert oder kontrahiert und das einenends ortsfest im Zylinderkopf (3) abgestützt ist,
**dadurch gekennzeichnet, dass** das Piezostapelelement (9a) anderenends mit einem im Zylinderkopf (3) längsbeweglich gelagerten Mitnehmer (10a) der Schrittmotoreinheit (5a) in Wirkverbindung steht, welcher Mitnehmer (10a) dem Einzelhub (24) des Piezostapelelements (9a) folgt und mit dem Stößel (6) schaltbar rutschfest verbindbar ist.

2. Stellvorrichtung nach Anspruch 1, **dadurch gekennzeichnet, dass** der Mitnehmer (10a) als piezoelektrische Klemmvorrichtung (26) ausgebildet ist, die einen elastisch verformbaren und zu einer Außenmantelfläche (30) des Stößels (6) benachbart verlaufenden Radialabschnitt (31) aufweist, der von ein oder mehreren elektrisch ansteuerbaren Piezokeramikelementen (29) der Klemmvorrichtung (26) quer zur Längsrichtung des Stößels (6) kraftbeaufschlagbar ist, wobei ein Radialspalt (32) zwischen dem Radialabschnitt (31) und der Außenmantelfläche (30) des Stößels (6) durch Expansion der Piezokeramikelemente (29) infolge Änderung einer elektrischen Spannung an den Piezokeramikelementen (29) zur rutschfesten Verbindung des Mitnehmers (10a) mit dem Stößel (6) aufhebbar ist.

3. Stellvorrichtung nach Anspruch 2, **dadurch gekennzeichnet, dass** die Klemmvorrichtung (26) über eine am Radialabschnitt (31) und/oder an der Außenmantelfläche (30) des Stößels (6) angeordnete Mikroverzahnung (33) formschlüssig mit dem Stößel (6) verbindbar ist.

4. Stellvorrichtung nach einem der Ansprüche 1 bis 3, **dadurch gekennzeichnet, dass** die Schrittmotoreinheit (5a) ein einenends ortsfest im Zylinderkopf (3) abgestütztes Federmittel (11a) aufweist, das anderenends den Mitnehmer (10a) in Richtung des Piezostapelelements (9a) kraftbeaufschlagt.

5. Stellvorrichtung nach Anspruch 4, **dadurch gekennzeichnet, dass** das Piezostapelelement (9a) und/oder das Federmittel (11a) einen im wesentlichen kreisförmigen Querschnitt mit einer zentrischen Ausnehmung (36) aufweisen, in der der Stößel (6) verläuft.

6. Stellvorrichtung nach Anspruch 4 oder 5, **dadurch gekennzeichnet, dass** der Linearaktuator (4) zwei Schrittmotoreinheiten (5a, 5b) umfasst, die so ansteuerbar sind, dass das Piezostapelelement (9a) der ersten Schrittmotoreinheit (5a) um den Einzelhub (24) expandiert, während das Piezostapelelement (9b) der zweiten Schrittmotoreinheit (5b) um den Einzelhub (24) kontrahiert, wobei der Stößel (6) mit den Mitnehmern (10a, 10b) der Schrittmotoreinheiten (5a, 5b) alternierend verbunden ist.

7. Stellvorrichtung nach Anspruch 6, **dadurch gekennzeichnet, dass** der Ventilhebel (12) als Schwinghebel (13) ausgebildet ist und von dem Stößel (6) zwischen einem als Zylinderkopflagerstelle (14) dienenden ersten Endabschnitt (15) und einem als Anlenkstelle (16) für das Gaswechselventil (2) dienenden zweiten Endabschnitt (17) beaufschlagt ist.

8. Stellvorrichtung nach Anspruch 6, **dadurch gekennzeichnet, dass** der Ventilhebel (12) als Kipphebel (34) ausgebildet ist, der einen vom Stößel (6) beaufschlagten ersten Endabschnitt (15), einen als Anlenkstelle (16) für das Gaswechselventil (2) dienenden zweiten Endabschnitt (17) sowie eine zwischen dem ersten Endabschnitt (15) und dem zweiten Endabschnitt (17) angeordnete Zylinderkopflagerstelle (14) aufweist.

9. Stellvorrichtung nach Anspruch 7 oder 8, **dadurch gekennzeichnet, dass** die Anlenkstelle (16) als Zug-Druck-Gelenk (21) zur Betätigung des ventilfederkraftfreien Gaswechselventils (2) sowohl in Öffnungsrichtung als auch in Schließrichtung des Gaswechselventils (2) ausgebildet ist.

## Claims

1. Electrical actuating apparatus (1) for variable opening and closing actuation of a gas exchange valve (2) in a cylinder head (3) of an internal combustion engine, having a linear actuator (4), which is supported in a fixed position in the cylinder head (3), and a valve lever (12) which is arranged in the actuation sequence between a tappet (6) of the linear actuator (4) and the gas exchange valve (2) and converts a total stroke (35a) of the tappet (6) into a total stroke (35b) of the gas exchange valve (2) which is greater than the said total stroke of the tappet, with the linear actuator (4) comprising at least one electrically driveable stepper motor unit (5a) which moves the tappet (6) successively by a discrete individual stroke (24) in each case, it being possible to variably adjust the total stroke (35a) of the tappet (6) by adding up a variable number of discrete individual strokes (24), with a piezo-stack element (9a) which comprises piezoceramic discs (23) which are connected in series and can be electrically driven being arranged in the stepper motor unit (5a), the said piezo-stack element being active in the stroke direction of the tappet (6) and being expanded or contracted by the discrete individual stroke (24) in a reversible manner when an electric voltage across the piezo-stack element (9a) changes, and being supported in a fixed position in the cylinder head (3) at one end, **characterized in that** the piezo-stack element (9a) is operatively connected to a driver (10a) of the stepper motor unit (5a) at the other end, the said driver (10a) being mounted in a longitudinally displaceable manner in the cylinder head (3) and following the individual stroke (24) of the piezo-stack element (9a) and it being possible to connect the said driver to the tappet (6) in a switchably slip-resistant manner.

2. Actuating apparatus according to Claim 1, **characterized in that** the driver (10a) is in the form of a piezoelectric clamping apparatus (26) which has an elastically deformable radial section (31) which runs adjacent to an outer casing surface (30) of the tappet (6) and can be subjected to the action of force by one or more electrically driveable piezoceramic elements (29) of the clamping apparatus (26) transverse to the longitudinal direction of the tappet (6), it being possible to eliminate a radial gap (32) between the radial section (31) and the outer casing surface (30) of the tappet (6) by expansion of the piezoceramic elements (29) as a result of a change in an electric voltage across the piezoceramic elements (29) for slip-resistant connection of the driver (10a) to the tappet (6).

3. Actuating apparatus according to Claim 2, **characterized in that** the clamping apparatus (26) can be connected to the tappet (6) in an interlocking manner by means of a micro-tooth system (33) which is arranged on the radial section (31) and/or on the outer casing surface (30) of the tappet (6).

4. Actuating apparatus according to one of Claims 1 to 3, **characterized in that** the stepper motor unit (5a) has a spring means (11a) which is supported in a fixed position in the cylinder head (3) at one end and subjects the driver (10a) to the action of force in the direction of the piezo-stack element (9a) at the other end.

5. Actuating apparatus according to Claim 4, **characterized in that** the piezo-stack element (9a) and/or the spring means (11a) have/has a substantially circular cross section with a central recess (36) in which the tappet (6) runs.

6. Actuating apparatus according to Claim 4 or 5, **characterized in that** the linear actuator (4) comprises two stepper motor units (5a, 5b) which can be driven such that the piezo-stack element (9a) of the first stepper motor unit (5a) expands by the individual stroke (24), while the piezo-stack element (9b) of the second stepper motor unit (5b) contracts by the individual stroke (24), with the tappet (6) being alternately connected to the drivers (10a, 10b) of the stepper motor units (5a, 5b).

7. Actuating apparatus according to Claim 6, **characterized in that** the valve lever (12) is in the form of an oscillating lever (13) and is acted on by the tappet (6) between a first end section (15) which serves as a cylinder head bearing point (14) and a second end section (17) which serves as an articulation point (16) for the gas exchange valve (2).

8. Actuating apparatus according to Claim 6, **characterized in that** the valve lever (12) is in the form of a tilting lever (34) which has a first end section (15) which is acted on by the tappet (6), a second end section (17) which serves as an articulation point (16) for the gas exchange valve (2), and a cylinder head bearing point (14) which is arranged between the first end section (15) and the second end section (17).

9. Actuating apparatus according to Claim 7 or 8, **characterized in that** the articulation point (16) is in the form of a tension/compression joint (21) for actuating the gas exchange valve (2), which is not subjected to valve spring force, both in the opening direction and also in the closing direction of the gas exchange valve (2).

## Revendications

1. Dispositif d'actionnement électrique (1) pour l'actionnement d'ouverture et de fermeture variable d'une soupape d'échange gazeux (2) dans une culasse (3) d'un moteur à combustion interne, comprenant un actionneur linéaire (4) supporté fixement dans la culasse (3) et un levier de soupape (12) disposé dans le flux d'actionnement entre un poussoir (6) de l'actionneur linéaire (4) et la soupape d'échange gazeux (2), qui convertit une course totale (35a) du poussoir (6) en une course totale (35b) plus grande de la soupape d'échange gazeux (2),
l'actionneur linéaire (4) comprenant au moins une unité de moteur pas à pas (5a) pouvant être commandée électriquement, qui déplace le poussoir (6) de manière successive d'une course individuelle discrète (24) respective,
la course totale (35a) du poussoir (6) pouvant être ajustée de manière variable par addition d'un nombre variable de courses individuelles discrètes (24),
un élément à empilages piézoélectriques (9a) pouvant être commandé électriquement et comprenant des disques en céramique piézoélectriques (23) montés en série étant disposé dans l'unité de moteur pas à pas (5a), lequel agit dans la direction de la course du poussoir (6) et en cas de variation d'une tension électrique au niveau de l'élément à empilages piézoélectriques (9a), se dilate ou se contracte de manière réversible de la course individuelle discrète (24), et est supporté fixement à une extrémité dans la culasse (3),
**caractérisé en ce que** l'élément à empilages piézoélectriques (9a) est en liaison fonctionnelle à l'autre extrémité avec un dispositif d'entraînement (10a) de l'unité de moteur pas à pas (5a) monté de manière déplaçable longitudinalement dans la culasse (3), lequel dispositif d'entraînement (10a) suit la course individuelle (24) de l'élément à empilages piézoélectriques (9a) et peut être connecté au poussoir (6) de manière commutable et de manière à résister aux glissements.

2. Dispositif d'actionnement selon la revendication 1, **caractérisé en ce que** le dispositif d'entraînement (10a) est réalisé sous forme de dispositif de serrage piézoélectrique (26) qui présente une portion radiale (31) déformable élastiquement et s'étendant à proximité d'une surface d'enveloppe extérieure (30) du poussoir (6), qui peut être sollicitée par force par un ou plusieurs éléments en céramique piézoélectriques (29) commandables électriquement du dispositif de serrage (26) transversalement à la direction longitudinale du poussoir (6), une fente radiale (32) entre la portion radiale (31) et la surface d'enveloppe extérieure (30) du poussoir (6) pouvant être supprimée par l'expansion des éléments en céramique piézoélectriques (29) pour connecter, de manière à résister au glissement, le dispositif d'entraînement (10a) au poussoir (6).

3. Dispositif d'actionnement selon la revendication 2, **caractérisé en ce que** le dispositif de serrage (26) peut être connecté par correspondance géométrique avec le poussoir (6) par le biais d'une microdenture (33) disposée sur la portion radiale (31) et/ou sur la surface d'enveloppe extérieure (30) du poussoir (6).

4. Dispositif d'actionnement selon l'une quelconque des revendications 1 à 3, **caractérisé en ce que** l'unité de moteur pas à pas (5a) présente un moyen de ressort (11a) supporté, à une extrémité, fixement dans la culasse (3), qui sollicite par force, à l'autre extrémité, le dispositif d'entraînement (10a) dans la direction de l'élément à empilages piézoélectriques (9a).

5. Dispositif d'actionnement selon la revendication 4, **caractérisé en ce que** l'élément à empilages piézoélectriques (9a) et/ou le moyen de ressort (11a) présentent une section transversale essentiellement circulaire avec un évidement central (36), dans lequel passe le poussoir (6).

6. Dispositif d'actionnement selon la revendication 4 ou 5, **caractérisé en ce que** l'actionneur linéaire (4) comprend deux unités de moteur pas à pas (5a, 5b) qui peuvent être commandées de telle sorte que l'élément à empilages piézoélectriques (9a) de la première unité de moteur pas à pas (5a) se dilate de la course individuelle (24), tandis que l'élément à empilages piézoélectriques (9b) de la deuxième unité de moteur pas à pas (5b) se contracte de la course individuelle (24), le poussoir (6) étant connecté en alternance avec les dispositifs d'entraînement (10a, 10b) des unités de moteur pas à pas (5a, 5b).

7. Dispositif d'actionnement selon la revendication 6, **caractérisé en ce que** le levier de soupape (12) est réalisé sous forme de levier oscillant (13) et est sollicité par le poussoir (6) entre une première portion d'extrémité (15) servant de point d'appui (14) pour la culasse et une deuxième portion d'extrémité (17) servant de point d'articulation (16) pour la soupape d'échange gazeux (2).

8. Dispositif d'actinnement selon la revendication 6, **caractérisé en ce que** le levier de soupape (12) est réalisé sous forme de levier basculant (34) qui présente une première portion d'extrémité (15) sollicitée par le poussoir (6), une deuxième portion d'extrémité (17) servant de point d'articulation (16) pour la soupape d'échange gazeux (2) et un point d'appui (14) pour la culasse disposé entre la première portion d'extrémité (15) et la deuxième portion d'extrémité (17).

9. Dispositif d'actionnement selon la revendication 7 ou 8, **caractérisé en ce que** le point d'articulation (16) est réalisé en tant qu'articulation à traction-compression (21) pour l'actionnement de la soupape d'échange gazeux (2) sans force de ressort à la fois dans la direction d'ouverture et dans la direction de fermeture de la soupape d'échange gazeux (2).
